Europäisches Patentamt

**European Patent Office**

**Office européen des brevets**

(19)

(11) Publication number: **0 047 388**
A2

(12)

# EUROPEAN PATENT APPLICATION

(21) Application number: **81105942.7**

(22) Date of filing: **28.07.81**

(51) Int. Cl.³: **G 06 F 15/20**

(30) Priority: **05.09.80 US 184671**

(43) Date of publication of application: **17.03.82**
**Bulletin 82/11**

(84) Designated Contracting States: **DE FR GB IT**

(71) Applicant: **Rockwell International Corporation, 2230 East Imperial Highway, El Segundo, California 90245 (US)**

(72) Inventor: **Larsen, Robert Peter, 2215 Calle Ultimo, Fullerton CA 92633 (US)**
Inventor: **Luisi, James Allen, 1142 Dagna Place, Anaheim CA 92806 (US)**

(74) Representative: **Wagner, Karl H., Dipl.-Ing., P.O. Box 22 02 46 Gewuerzmuehlstrasse 5, D-8000 München 22 (DE)**

(54) Computer aided design system.

(57) A computer aided design system comprising means for representing a plurality of electronic devices having respective predetermined electronic operating characteristics and respective predetermined geometrical configurations on a display; means for representing electrical connections between the electronic devices on the display to produce a representation of an electronic circuit on the display; means for automatically calculating the performance of the circuit defined by the representation of the circuit; and means for testing the geometrical configurations defined by the representation of the electronic circuit against predetermined geometrical design criteria.

ACTORUM AG

- 1 -

COMPUTER AIDED DESIGN SYSTEM

0047388

Field of the Invention

The invention is concerned with circuit design, and in particular to the automation and optimization of circuit design using computer aided techniques.

Background of the Invention

There are various methods of computer-aided design systems known in the prior art. The most widely used systems utilize the so-called polygonal methodology in which mask polygons are the primary means of describing the microelectronic circuit layout. The polygons for each mask layer are first described using a layout grid, and then subsequently are entered into the computer by digitizing the data, or using an electronic pen-tablet.

The design rule checking is performed by relational pair comparing of intramask and intermask polygons. The salient deficiency in the prior-art computer-aided design methodology is the difficulty of the designer in conducting automatic circuit analysis, logic simulation and layout verification with respect to a priori device functions and performance objectives. The prior art methodology also possesses problems with respect to the design portability to various fabrication processes.

Examples of prior art computer-aided design systems are discussed in the patents and technical literature listed in the next sections.

- 2 -

References

R. P. Larsen, "Symbolic Layout System Speeds Mask Design for ICs", Electronics, Jul 1978

E. Lindberg "ANP/NAP Bulletins", Inst. of Circ. Theory & Telecom., Techn. Univ. of Denmark, DK-2800 Lyngby, Dec. 1978

Techbriefs from Marconi Res. Lab., Nos. 604, 604/2, 605, 606, 608, 610, 611/1, 612, 613/1, 615, 620, 621, GEC-Marconi Elec. Ltd., Great Baddow, Chelmsford, Essex CM2 8HN, GB

R. Rosen, F. L. Tevelow, "CAD/CAM Systems Group", Harry Diamond Lab., Res. and Eng. Support Div., Adelphi, Maryland, Mar. 1978

B. Dembart, L. Milliman, "A Digital Comp. Prog. for Transient Analysis of Elec. Circuits", Vol. 1-User's Guide, Boeing Comp. Svs., Inc., Space & Military Appl. Div., Seattle, Washington, Oct. 1976

B. Dembart, L. Milliman, "A Digital Comp. Prog. for Transient Analysis of Elec. Circuits, Vol. 2-Program Manual, Boeing Comp. Svcs., Inc., Space & Military Appl. Div., Seattle, Washington, Oct. 1976

L. D. Milliman, "A Digital Comp. Prog. for Transient Analysis of Elec. Circuits, Vol. 3-Computer Prog. Test Procedures, Boeing Comp. Svcs., Inc., Space & Military Appl. Div., Seattle, Washington, Oct. 1976

LOGCAP Reference Guide, Version 313, Ungerman Assoc., Los Altos, California, Nat. CSS, Inc., Wilton, Connecticut, Apr 1978

ISPICE - "Oper. Amplifier Model Note", Nat. CSS, Inc., Wilton, Connecticut, Jun 1978

ISPICE - "Diode Model Note", Nat. CSS, Inc., Wilton, Connecticut, Aug. 1978

ISPICE - "Junction FET Model Note", Nat. CSS, Inc., Wilton, Connecticut, Aug. 1978

ISPICE - "Bipolar Junction Transistor Model Note", Nat. CSS, Inc., Wilton, Connecticut, Oct. 1978

ISPICE - "Bipolar Integrated Transistor Model Note", Nat. CSS, Inc., Wilton, Connecticut, Jun 1978

ISPICE - "Extensions to the ISPICE MOSFET Model", Nat. CSS, Inc., Wilton, Connecticut, Aug 1978

0047388

- 3 -

References (continued)

ISPICE - "Short Channel MOSFET Model Note", Nat. CSS, Inc., Wilton, Connecticut, Sep 1978

ISPICE - Reference Guide, Release 2, Nat. CSS, Inc., Norwalk, Connecticut, Jun 1978

"Computer-Aided Design and Characterization of Digital MOS Integrated Circuits", Dov Frohman-Bentchkowski, L. Vadasz, IEEE J. of Solid-State Circuits, Vol. SC-4, No. 2, Apr 1969

"Versatile Mask Generation Techniques for Custom Microelectronic Devices:, R. P. Larsen, Proceedings 15th Design Automation Conference, Las Vega, Nevada, June 19-21, 1978, pp. 193-198.

"VLSI Pushes Super-CAD Techniques",  Martin Marshall and Larry Waller, Electronics, July 31, 1980, pp. 73-79.

Patent References

Hart, Donald E., & Jacks, Edwin L., "Computer-Aided Graphical Analysis", U.S. Pat. No. 3,534,396, issued Oct. 27, 1965

Dyer, Lester W., et al, "Circuit Design by an Automated Data Processing Machine", U.S. Pat. No. 3,622,762, issued Nov. 23, 1971

Freitag, Harlow, "Element Placement System", U.S. Pat. No. 3,654,615, issued Apr 4, 1972

Ramirez, Jr., et al, "Algorithm to Minimize Iterative Computation in a Process for the Analysis or Design of a Physical System", U.S. Pat. No. 3,702,003, issued Oct. 31, 1972

Eskew, Mark F. & Hyde, Beverly F., "Process and System for Routing Interconnections Between Logic System Elements", U.S. Pat. No. No. 3,702,004, issued Oct. 31, 1972

Knowlton, Kenneth C., "Interactive Input-Output Computer Terminal with Automatic Relabeling of Keyboard", U.S. Pat. No. 3,879,722, issued Apr. 22, 1975

Villers, Phillippe, "Method for Automating the Production of Engineering Documentation Utilizing an Integrated Digital Data Base Representation of the Documentation", U.S. Pat. No. 3,930,237, issued Dec. 30, 1975

Green, Paul F. & Mead, Barry B., "Graphics Generator", U.S. Pat. No. 4,146,925, issued Mar. 27, 1979

Frey, Richard C. et al, "Apparatus for Presenting a Sequence of Fixed Pictures", U.S. Pat. No. 4,181,971, issued Jan. 1, 1980

0047388

- 5 -

## Summary of the Invention

Briefly, and in general terms, the invention provides a computer aided design system including means for representing a plurality of electronic devices having respective predetermined electronic operating characteristics and respective predetermined geometrical configurations on a display, and means for representing electrical connections between the ëlectronic devices on the display to produce a representation of an electronic circuit on the display. There are further provided means for automatically calculating the performance of the circuit defined by the representation of the circuit, and means for testing the geometrical configurations defined by the representation of the electronic circuit against predetermined geometrical design criteria.

The present invention is more particularly concerned with microelectronic circuit design and layout system that permits incorporation of circuit layout and fabrication process influences on individual device performances. The system creates an interactive design environment in which the designer composes a candidate circuit layout or a display utilizing a symbolic notation keyboard. The design analysis feature of the system utilizes the actual circuit topology of the layout to account for the influence of interconnect structures. The mathematical models used in analysis to predict performance are derived from the physical structure that would result from a candidate fabrication process being considered to construct the device.

0047388

- 7 -

The novel features which are considered as characteristic for the invention are set forth in particular in the appended claims. The invention itself, however, both as to its construction and its method of operation, together with additional objects and advantages thereof will be best understood from the following description of specific embodiments when read in connection with the accompanying drawings.

Brief Description of the Drawing

FIG. 1 shows a highly simplified block diagram of the sequence of steps in utilizing computer aided design in the fabrication of semiconductor devices;

FIG. 2 is a highly simplified block diagram of the software structure of a computer aided design system;

FIG. 3a, b, and c illustrates how each point, line, or area primitive is designed by the present invention

FIG. 4 illustrates the incidence rectangle according to the present invention;

FIG. 5 is another illustration of the incidence rectangle according to the present invention;

FIG. 6a and b define the contiguous situation by their explicitly or implicitly according to the present invention.

FIG. 7 illustrates the cover situation according to the present invention;

FIG. 8 illustrates the protect situation according to the present invention;

FIG. 9 illustrates the mask geometries for contiguous situation according to the present invention;

FIG. 10 illustrates the mask geometries for the cover situation according to the present invention;

FIG. 11 illustrates the mask geometries for a protect situation according to the present invention;

FIG. 12a and 12b illustrate the geometric placement according to the present invention according to both symbolic design and mask geometry;

FIG. 13 illustrates the mask geometry edge mapping according to the present invention;

FIG. 14 illustrates the mask geometries algorithm in a flow chart form according to the present invention;

FIG. 15 illustrates a representation of a rectangle according to the present invention;

FIG. 16a to 16e illustrates the relationship between the rectangle and the polygon according to the present invention;

FIG. 17 illustrates a flow chart of the rectangle to polygon algorithm according to the present invention;

FIG. 18a, b, c, d and e illustrate the problem of four adjacent points with unequal sizes according to the present invention;

FIG. 19 illustrates the global strategy of the design system according to the present invention;

FIG. 20 shows a highly simplified block diagram of the computer-aided design process of the prior art;

FIG. 21 is a highly simplified block diagram of the computer-aided design system according to the present invention;

FIG. 22 is a representation of the symbolic design of a CMOS inverter according to the prior art;

FIG. 23 is a representation of the same CMOS inverter as drawn with a computer-aided design system according to the present invention;

FIG. 24 is a highly simplified block diagram of a system implementation of the computer-aided design system according to the present invention;

0047388

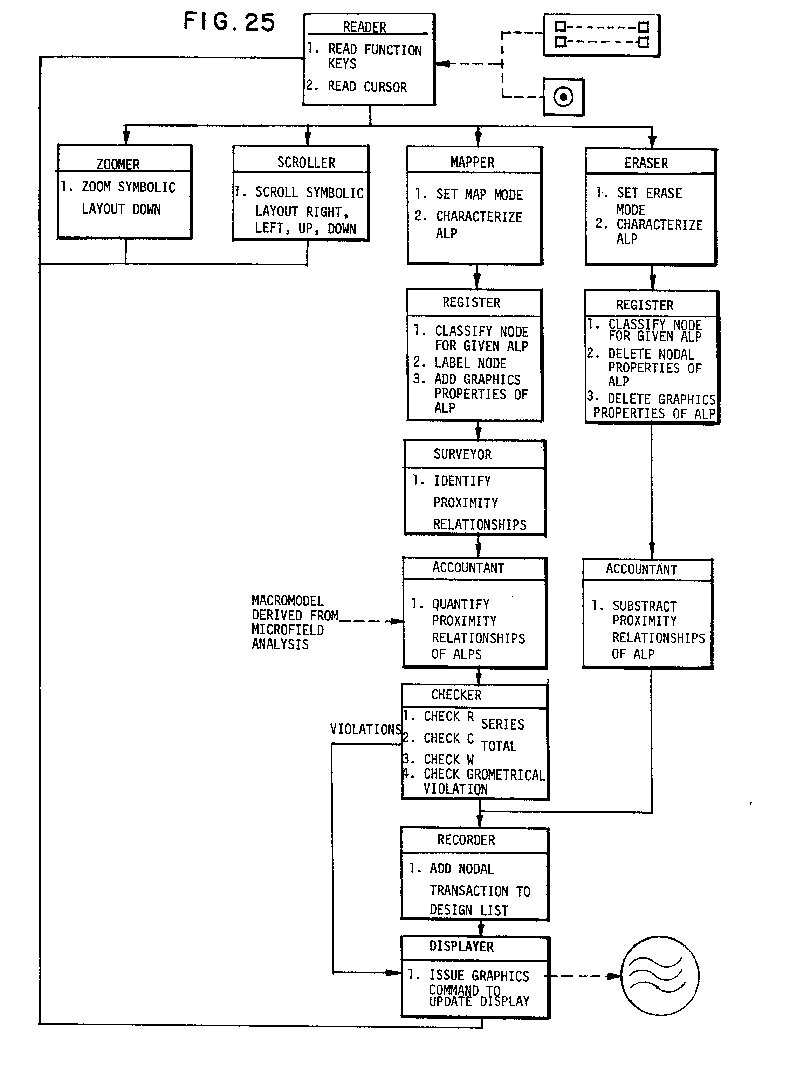

FIG. 25 is a highly simplified block diagram of the symbolic design software architecture according to the present invention;

FIG. 26 is a highly simplified block diagram of the circuit analysis software architecture according to the present invention.

0047388

Description of the Preferred Embodiment

## TABLE OF CONTENTS

Introduction

**PLA** Primitive Relationships

Binary Relational Parameters

      CLASS I:     Interior Relationship

      CLASS II:    Boundary Relationship

      CLASS III: Corner Relationship

The Protect Situation

Mask Geometry Placement

Mask Geometries Algorithm

Rectangle → Polygon Algorithm

Specifying Mask Geometries

System Implementation

Introduction

The present invention is an interactive computer-aided design (CAD) system specifically aimed at the synthesis of modules to be integrated into VLSI device designs. The system is specialized for the device designer to provide an interactive facility for manipulating layout primitives (points, lines, areas) in composing circuit topology on a color graphics display. The description herein defines the primary algorithms and concepts underlying the generation of mask geometries related to the color enhanced - symbolic design. The mask geometries algorithm described enables the device designer to interactively explore intra and inter mask geometry relationships. This color graphics exploration can be performed in concert with lithography and process engineering. It is anticipated that the future need for mask color guides used for visual examination of intra and inter mask geometry relationships will be virtually eliminated. This cost reduction could be substantial when considering the elapsed time delay in receiving color guides with present technology.

One defines a versatile mask geometries algorithm that is optimal for interactive color graphics processing. A language is utilized to define the mapping variables required to determine the geometrical relationships implied in the symbolic design. The analytical and conceptual aspects underlying the mask geometries algorithm are defined to a level where software development activities could commence. An example is also described to provide the reader with an insight into the mechanics of the algorithm and the associated date requirements.

The system according to the present invention (given the name µCAD) is specialized for the device designer so that circuit and logic functions are easy to mentally construct and graphically compose. Symbolic representations of circuit structures are displayed and manipulated interactively on a color graphics display to promote the computer-aided translation of "function" into "topology" without regard to mask geometric details. The device designer is uncoupled from the process world and need not anticipate all the process variations in order to capture the solution of an immediate applications opportunity in a workable custom VLSI design. The device designer thinks at a higher level of abstraction which allows these improvements in productivity:

1) layouts can be performed by a multitude of remote design communities, closer to the applications, than in the prior art practice;

2) symbolic manipulation can be used as a short-hand methodology for quickly exploring circuit and layout alternatives.

3) changes in processing techniques can be exploited without requiring detailed redesign of existing circuits. (This includes very selective reductions in dimensions on any mask layer);

4) a uniform interpretation is applied to each symbol transformation automatically, according to rules defined by processing requirements. The transformations can realize arbitrary geometric detail with a full exercise of advantages based on symbol environment;

5) the creation, transmission, and storage of detailed design information is greatly reduced;

6) the communications of essential design information is concisely summarized in compact tables;

7) designs are portable into different factories without concerns about mask details peculiar to each process. New mask layers and/or different local dimensions can be defined, at will, and quickly rederived from the symbolic design.

It must be realized that a dimension of any micro structure cannot be characterized by a single number. Dimensions change systematically as masks are made and as wafers are processed through a variety of steps. The designer thinks in terms of a nominal dimension which characterize electrical phenomena. The process operator sees a range of dimensions through microscopic inspection of the wafers. First, the operator sees the dimension of a developed image in photoresist, then the dimension transforms by etching into an oxide layer, and finally it is observed as an end result in a d-dimensional structure. The mask makers see the results of plotters and changes during photo reduction (step and repeat) to make working tools.

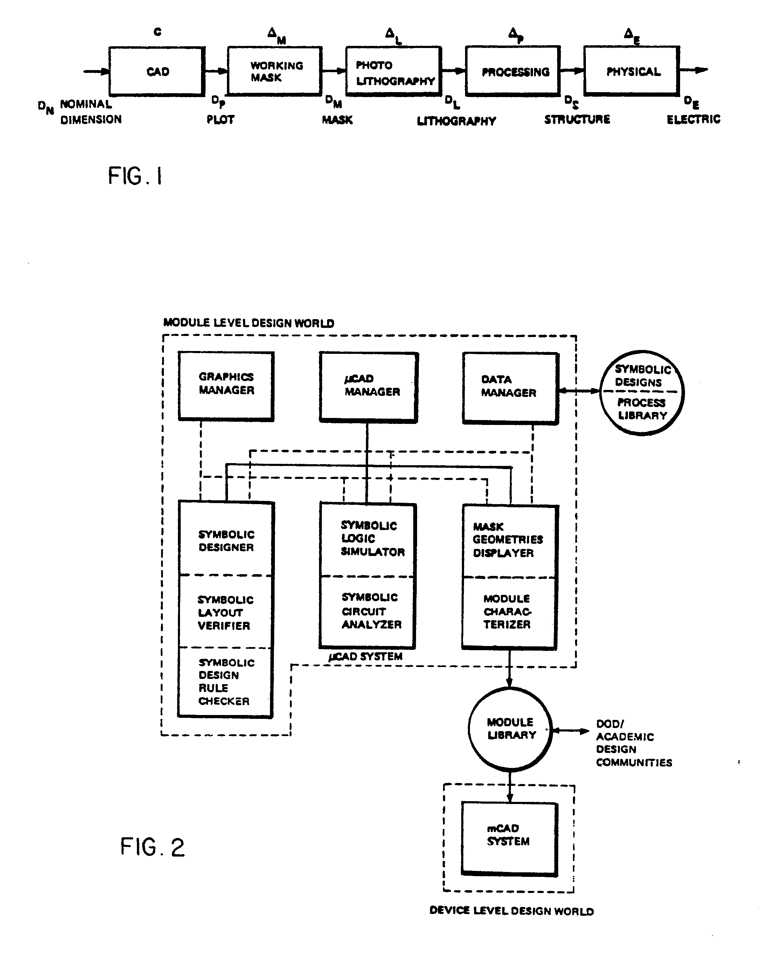

FIG. 1 illustrates the sequence of systematic changes in dimensions $(D_N)$ associated with the physical structures in a VLSI device. The sequence is shown as five steps from the CAD, to the working mask, to photolithography, and finally to the physical device itself.

The accounting mechanism utilized to correct for these systematic dimensional changes is the correction variable C.

$$C = -(\Delta_M + \Delta_L + \Delta_P + \Delta_E)$$

then $\qquad D_N + C + \Delta_M + \Delta_L + \Delta_P + \Delta_E = D_E$

and after cancelling $\qquad D_N = E_E$

then the nominal dimensions associated with the CAD is equal to the physical dimensions $D_E$.

The correction variable (C) is a budget which makes it possible for different people having different fabrication perspectives to communicate coherently and precisely about their part of the action. The fabrication community stays calibrated.

When geometric details are required, for example, during analysis of symbol interrelationships, µCAD can generate a colored overlay of the geometric shapes within an arbitrary "peek-window" from the symbolic design.

The impact on productivity of this capability to overlay geometric masking details in a color graphics presentation according to the present invention is significant. Light-tables are not required since it is not necessary to view stacks of blow-backs (color guides) of the mask layers in order to investigate detailed relationships and measurements. The electronic color graphic displays are more precisely aligned and more viewable. Variable magnification and superimposed micro rulers aids in the analysis of geometric detail with the goal of eliminating conceptual errors. Further, this presentation is transmittable to the device processing personnel to provide in-line inspection criteria.

The µCAD software architecture to support the interactive color graphics display of mask geometries can be represented pictorially in FIG. 2. FIG. 2 shows the module level design world representing the various software functions used in the µCAD system. These include a graphics match manager, a symbolic designer, a symbolic layout verifier, a symbolic design rule checker, the µCAD manager, the symbolic logic simulator, the symbolic circuit analyzer, the data manager, the mask geometries displayers, and the module characterizer. The data manager interfaces with external symbolic designs or process libraries. The module characterizer characterizes the module which is designed by the µCAD system and transmits the data associated with the design module to a module library. It is then possible that this module library be used by various design communities as well as a module component in a µCAD system for designing systems on the device level.

The mask geometries display software is an interactive processing package that extracts a window or portion of the symbolic design representing a module and transforms it into mask polygons. The module characterization software is a batch-oriented package that will transform the entire symbolic design of a module into a complete mask set. It will also characterize the module boundary and signal interface requirements so "paper modules" may be pen plotted for use in device architectural studies involving module arrangement, placement, signal interface/bussing design and device testability. These data will be telecommunicated to the central module library for storage and availability to the macroCAD (mCAD) system. The establishment of a module library will provide the device designer with a reportoire of previously designed modules to select from. This will be a means of reducing the level of custom design effort associated with VLSI devices leading to still greater productivity improvements.

One of the cardinal tenets underlying µCAD is the concept of utilizing color to enhance symbolic design methodology. Color provides a third dimensional effect. Color is already used by the device designer for manually expressing his circuit topology on grided mylar using colored pencils. The three dimensional effect of utilizing color to enhance symbolic designs also naturally relates to the multilevel three dimensional construction of the device; i.e., $n^+$ and $p^-$ diffusion, poly-silicon and aluminum. All these factors result in improving designer interpretation of VLSI symbolic designs which correspondingly improves designer productivity.

Since the conventional layout digitizing function consumes time and does not technically enhance the device design, µCAD proposes to eliminate the layout digitizing activities. This is accomplished through the utilization of interactive color graphics techniques that will enable the device designer to compose and explore alternate topological mechanizations with computer aid. The design evolves as a pictoral form in color which is referred to as the concept of color enhanced-symbolic design. The highly interactive input-output relationships, coupling the designer and the computer in a synergistic environment, is the power being captured and utilized in the μCAD concept.

In μCAD, the device designer utilizes design primitives to translate his mental imagings into the color enhanced-symbolic design displayed on the graphics screen. The repertoire of primitives available to the designer in μCAD is any combination of abstract topological structures composed of points, lines, and/or areas including polygons. These symbolic design primitives can be defined as follows, using standard BNF notation:

$$
\text{PLAP Set} \left\{ \begin{array}{l} \text{PLA Set} \left\{ \begin{array}{ll} \text{point:} & \text{<color> <symbol> <X/Y>} \\ \text{line:} & \text{<color> [<symbol>]<}X_1/Y_1\text{> <}X_2/Y_2\text{>} \\ \text{area:} & \text{<color> [<symbol>]<}X_1/Y_1\text{> <}X_2/Y_2\text{>} \end{array} \right. \\ \text{polygon:} \quad \text{<color> [<symbol>]<}X_1/Y_1\text{> ... <}X_n/Y_n\text{>} \end{array} \right.
$$

where the [ ] indicates an optional variable.

The PLA set of primitives represents the basic capability implemented in μCAD. The PLA set of primitives establishes the procedural mechanics available to the designer in composing a symbolic design. Extending the rectangular area to arbitrary polygons bridges the gap between symbolic design and the more conventional polygonal design. The PLAP set of primitives provides the designer with an extremely versatile means of composing symbolic designs (rectilinear masking) that incorporates angular masking capabilities. Any reference to symbolic design primitives in the remainder of this application refers to the PLA set of primitives only.

PLA Primitive Relationships

This section will discuss the masking relationships between the combinations of primitive pairs; i.e., point-point, point-line, point-area, line-line, line-area, and area-area. A set of binary relational parameters are defined that universally apply to PLA primitive relationships in generating mask geometries to realize continuity, cover and protect features. The continuity (contiguousness) feature describes the primitive pair relationship where the two mask rectangles associated with each primitive must be merged into a homogeneous polygon. The symbolic design is assumed to be referenced to a uniform grid with a scaling interval of $\lambda$. If two primitives are adjacent, a $\lambda = 1$ relationship in X or Y, the merging rule is that the smaller width edge is mapped on the larger edge to form a mask polygon. The cover and protect features are analogous to the present "gapping" concept that has existed for several years in conventional mask generation algorithm. It has been decided that "gapping" is a misnomer and should be deleted from μCAD linguistics. In this section, cover is analogous to orthogonal gapping and protect is analogous to diagonal gapping with regard to describing influence of symbol environments on mask geometries. Consequently, cover and protect will be the terms used to describe second order influences on primitive mask geometries. The cover feature is used when a primitive is influencing another primitive with a $\lambda = 1$ relationship in X or Y, such that the mutual edge is pushed or pulled to produce an overlap or cover effect. Similarly, the protect feature is used when a primitive is influencing another primitive with a $\lambda = 1$ relationship in both X and Y such that the mutual vertex is pushed back to exclude or protect a sensitive structure. Thus, it can be seen that the cover and protect features provide a means of achieving higher density within a specific set of process ground rules.

Binary Relational Parameters

In CAD, the process of composing a color enhanced - symbolic design by the device designer is via a repertoire of primitives. These symbolic design primitives can be categorized as points, lines and areas; hence we refer to the primitive set as PLA. Since an imaginary uniform grid is superimposed on the color graphics screen, each point is defined as a vertex and each line and area as a vertex pair. Each vertex consists of an X and Y coordinate related to a page offset representing the peek-window reference. It should be noted here that in µCAD the designer is completely insulated from maintenance of X, Y coordinates since the mapping of primitives on the color graphics screen is via a cursor. It is only the software that is intimately concerned with the maintenance of X, Y coordinates defining primitive placement.

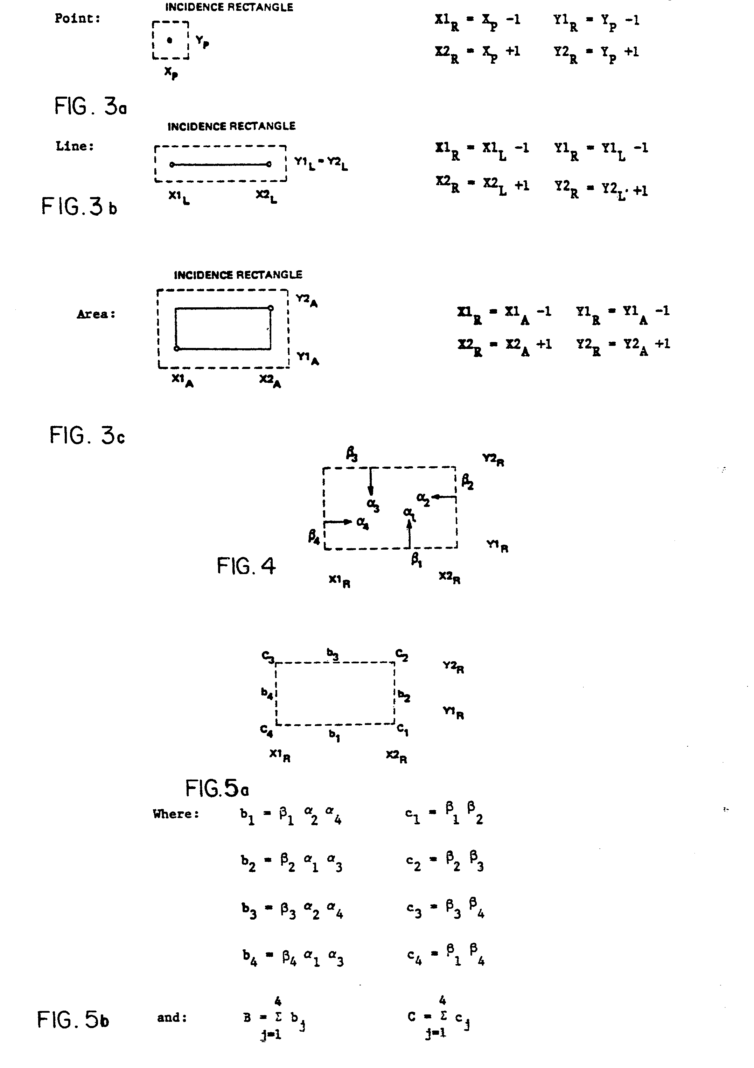

An incidence rectangle surrounding each PLA primitive will be defined such that each edge defining the incidence rectangle is $\lambda = 1$ from the defining vertex or vertex pair of the PLA. This can be illustrated in FIG. 3a, b, and c.

In classifying the relationship between two PLA primitives, it can be seen that the relationship between any candidate PLA vertex and a reference PLA incidence rectangle can be categorized into one of four possible classes; namely, interior, boundary, boundary corner, and exterior. The need to classify the relationship between two PLA primitives is to enable the mask geometries algorithm to perform appropriate mask geometry modification for contiguous, cover and protect situations. The incidence rectangle, illustrated with dashed lines in FIG. 4 is defined by the vertex pair $(X1_R/Y1_R)$, $(X2_R/Y2_R)$ which correspondingly defines the boundary edges associated with the reference PLA primitive.

The relationship of any candidate vertex associated with a PLA primitive and an edge defining the boundary rectangle of the reference PLA primitive is defined as:

Half Plane Binary Parameters = $\alpha_1$, $\alpha_2$, $\alpha_3$, $\alpha_4$
where: $\alpha_j$ = 1 if vertex is in half plane
$\alpha_j$ = 0 if vertex is not in half plane

Boundary Binary Parameters $= \beta_1, \beta_2, \beta_3, \beta_4$

where: $\beta_j = 1$ if vertex is on boundary edge

$\beta_j = 0$ if vertex is not on boundary edge

Given any candidate PLA primitive vertex $(X_V/Y_V)$ and the incidence rectangle of a reference PLA primitive defined by $(X1_R/Y1_R)$, $(X2_R/Y2_R)$ then the half plane binary parameters can be determined as follows:

$$\text{IF } Y_V > Y1_R \quad \text{THEN} \quad \alpha_1 = 1$$
$$\text{ELSE} \quad \alpha_1 = 0$$
$$\text{IF } X_V < X2_R \quad \text{THEN} \quad \alpha_2 = 1$$
$$\text{ELSE} \quad \alpha_2 = 0$$
$$\text{IF } Y_V < Y2_R \quad \text{THEN} \quad \alpha_3 = 1$$
$$\text{ELSE} \quad \alpha_3 = 0$$
$$\text{IF } X_V > X1_R \quad \text{THEN} \quad \alpha_4 = 1$$
$$\text{ELSE} \quad \alpha_4 = 0$$

In a similar manner and utilizing the same nomenclature, the boundary (edge) binary parameters can be determined as follows:

$$\text{IF } Y_V = Y1_R \quad \text{THEN} \quad \beta_1 = 1$$
$$\text{ELSE} \quad \beta_1 = 0$$
$$\text{IF } X_V = X2_R \quad \text{THEN} \quad \beta_2 = 1$$
$$\text{ELSE} \quad \beta_2 = 0$$
$$\text{IF } Y_V + Y2_R \quad \text{THEN} \quad \beta_3 = 1$$
$$\text{ELSE} \quad \beta_3 = 0$$
$$\text{IF } X_V + S1_R \quad \text{THEN} \quad \beta_4 = 1$$
$$\text{ELSE} \quad \beta_4 = 0$$

Given these binary parameters, $[\alpha_1, \alpha_2, \alpha_3, \alpha_4]$ and $[\beta_1, \beta_2, \beta_3, \beta_4]$, the relationship between any candidate PLA primitive vertex $(X_V/Y_V)$ and the incidence rectangle, associated with the reference PLA primitive and defined by the vertex pair $(X1_R/Y1_R)$, $(X2_R/Y2_R)$, can be classified as follows:

CLASS I:  Interior Relationship

By examining the previous diagram of the incidence rectangle, the interior relationship can be defined as follows:

$$I = \alpha_1 \; \alpha_2 \; \alpha_3 \; \alpha_4$$

Therefore, if $I = 1$, then the candidate PLA primitive vertex $(X_V/Y_V)$ experiences an interior relationship with the reference PLA primitive defining the incidence rectangle whose vertex pair is $(X1_R Y1_R)$, $(X2_R/Y2_R)$.

Conversely, if $I = 0$, no interior relationship exists between the PLA primitive pair.

CLASS II: Boundary Relationship

By examining the previous diagram of the incidence rectangle, the boundary relationship of the PLA primitive pair can be defined by the constituent edge properties as follows:

$$B = \beta_1 (\alpha_2\alpha_4) + \beta_2 (\alpha_1\alpha_3) + \beta_3 (\alpha_2\alpha_4) + \beta_4 (\alpha_1\alpha_3)$$

Simplifying the above function,

$$B = (\alpha_1\alpha_3) (\beta_2 + \beta_4) + (\alpha_2\alpha_4) (\beta_1 + \beta_3)$$

Therefore, if $B = 1$, then the candidate PLA primitive vertex $(X_V/Y_V)$ experiences a boundary relationship with the reference PLA primitive defining the incidence rectangle whose vertex pair is $(X1_R/Y1_R)$, $(X2_R/Y2_R)$.

Conversely, if $B = 0$, no boundary relationship exists between the PLA primitive pair.

CLASS III: Corner Relationship

By examining the previous diagram of the incidence rectangle, the corner relationship of the PLA primitive pair can be defined by the constituent vertex properties as follows:

$$C = \beta_1\beta_2 + \beta_2\beta_3 + \beta_3\beta_4 + \beta_1\beta_4$$

Therefore, if $C = 1$, then the candidate PLA primitive vertex $(X_V/Y_V)$ experiences a corner relationship with the reference PLA primitive defining the incidence rectangle whose vertex pair is $(X1_R/Y1_R)$, $(X2_R/Y2_R)$.

Conversely, if $C = 0$, no corner relationship exists between the PLA primitive pair.

Thus it can be seen that the binary parameters, I, B, C, completely characterize the PLA primitive pair relationships necessary to generate mask geometries for contiguous, cover, and protect situations.  These binary parameters will also serve to effectively control algorithmic processing as they are ideally suited in formulating decision table structures.

Primitive Relationships to Mask Geometries Mapping

Up to this point, the discussion has attempted to quantify the global relationship between a pair of PLA primitives.  The binary parameters I, B and C, as previously defined, served to quantify the relational situation.  Now the local relationship between the candidate PLA vertex $(X_V/Y_V)$ and the edges and vertices of the incidence rectangle related to the reference PLA primitive can be shown in FIG. 5.

Where:

$$b_1 = \beta_1\ \alpha_2\ \alpha_4 \qquad c_1 = \beta_1\ \beta_2$$
$$b_2 = \beta_2\ \alpha_1\ \alpha_3 \qquad c_2 = \beta_2\ \beta_3$$
$$b_3 = \beta_3\ \alpha_2\ \alpha_4 \qquad c_3 = \beta_3\ \beta_4$$
$$b_4 = \beta_4\ \alpha_1\ \alpha_3 \qquad c_4 = \beta_1\ \beta_4$$

and:

$$B = \sum_{j=1}^{4} b_j \qquad C = \sum_{j=1}^{4} c_j$$

The Boolean expressions in FIG. 5 define B and C and are in the conventional sum of products connonical form.

It can be further seen that each $b_j$ is associated with an edge of the incidence rectangle and each $c_j$ is associated with a vertex of the incidence rectangle. These $b_j$ and $c_j$ binary parameters define the local edge-vertex relationships existing between the PLA primitive pair. The algorithmic significance is that the $b_j$ and $c_j$ binary parameters imply spatial orientation of the PLA primitive pair and can be used in structuring the calculations associated with the mask geometries algorithm.

The Contiguous Situation

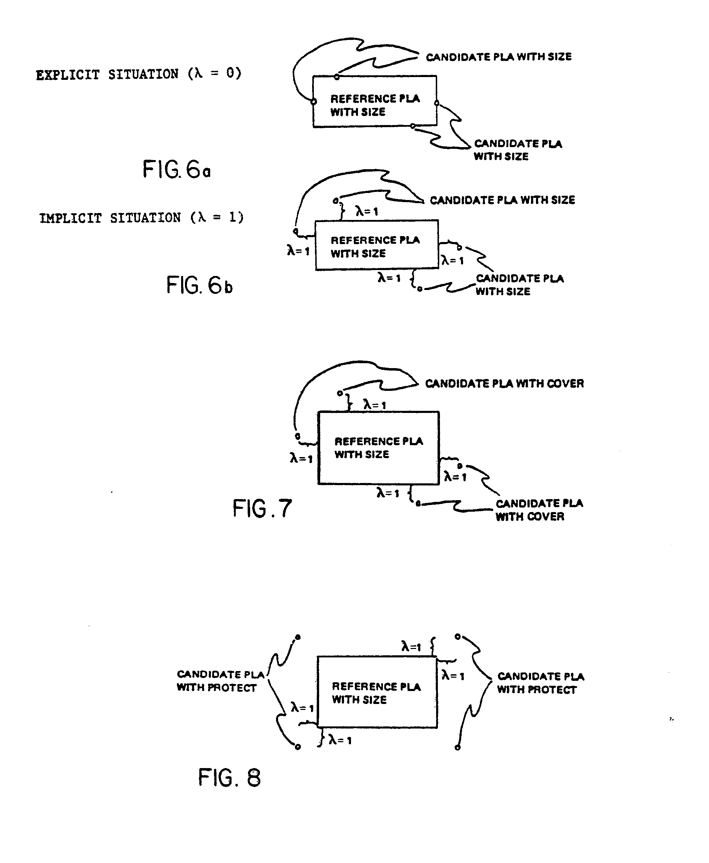

The contiguous situation is defined as being any PLA primitive pair that experiences an orthogonal relationship of $\lambda = 0$ or $\lambda = 1$ and both possessing the SIZE property. These situations can be generalized in FIG. 6a and 6b.

Explicit          $(\lambda = 0)$

Implicit          $(\lambda = 1)$

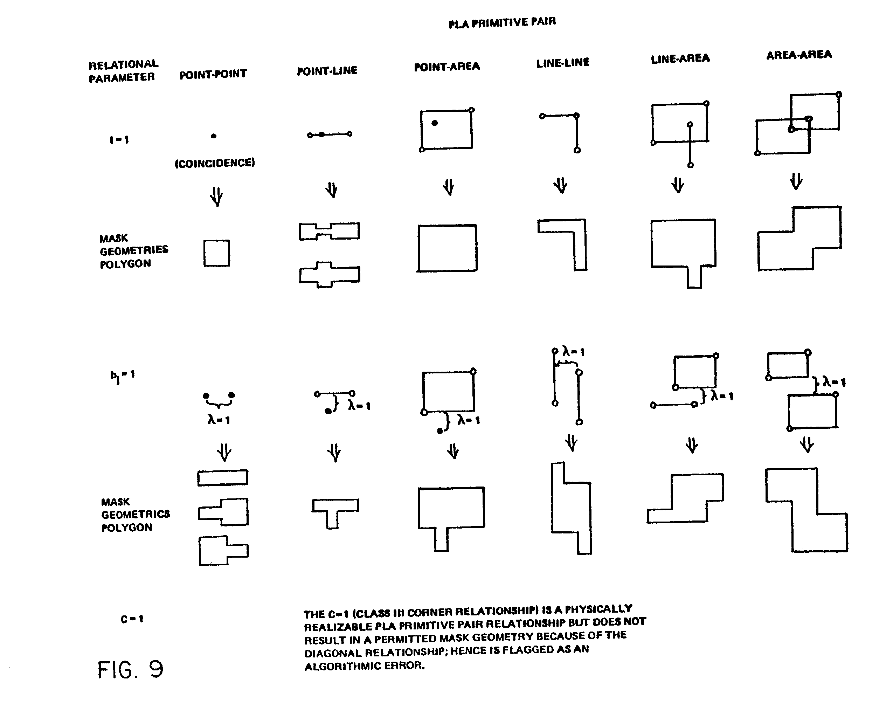

An important rule governs the remapping of the mutual edges of the PLA primitive pair experiencing the contiguous situation. If the mutual edges are unequal, the smaller sized edge is extended to or remapped on the larger sized edge to form a contiguous polygon. The various combinations of PLA primitive pairs and the resulting mask geometries are presented in FIG. 9 showing the table of mask geometries for contiguous situation.

The Cover Situation

The cover situation is defined as being any PLA primitive pair that experiences an orthogonal relationship of $\lambda = 1$ in which the reference PLA primitive possesses a SIZE property and the candidate PLA primitive possesses a COVER property. This situation can be generalized in FIG. 7.

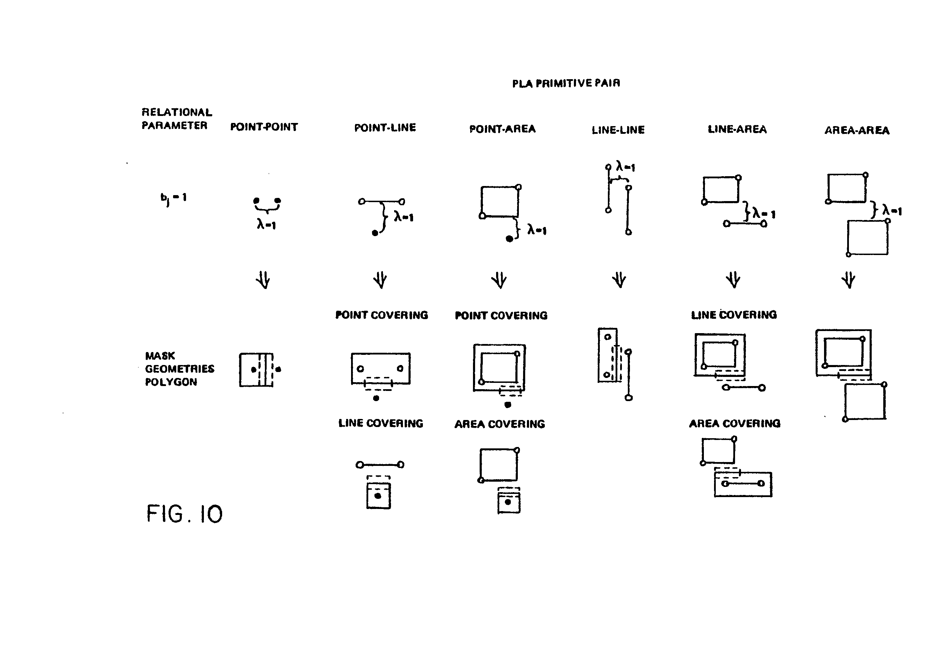

As shown in FIG. 7, the candidate PLA possesses the COVER property. Therefore, the mutual edge of the reference PLA primitive is experiencing a "pushing" or "pulling" effect inflicted by the candidate PLA. The degree of influence on the mutual edge is defined by the COVER value. It should be noted that the COVER property only modifies the related edge geometries of the reference PLA primitive. The various combinations of PLA primitive pairs and the resulting mask geometries experiencing the COVER influence are presented in FIG. 10, showing the mask geometries for cover situation.

The Protect Situation

The protect situation is defined as being any PLA primitive pair that experiences a diagonal relationship of $\lambda = 1$ in both X and Y in which the reference PLA primitive possesses a SIZE property and the candidate PLA primitive possesses a PROTECT property. This situation can be generalized in FIG. 8.

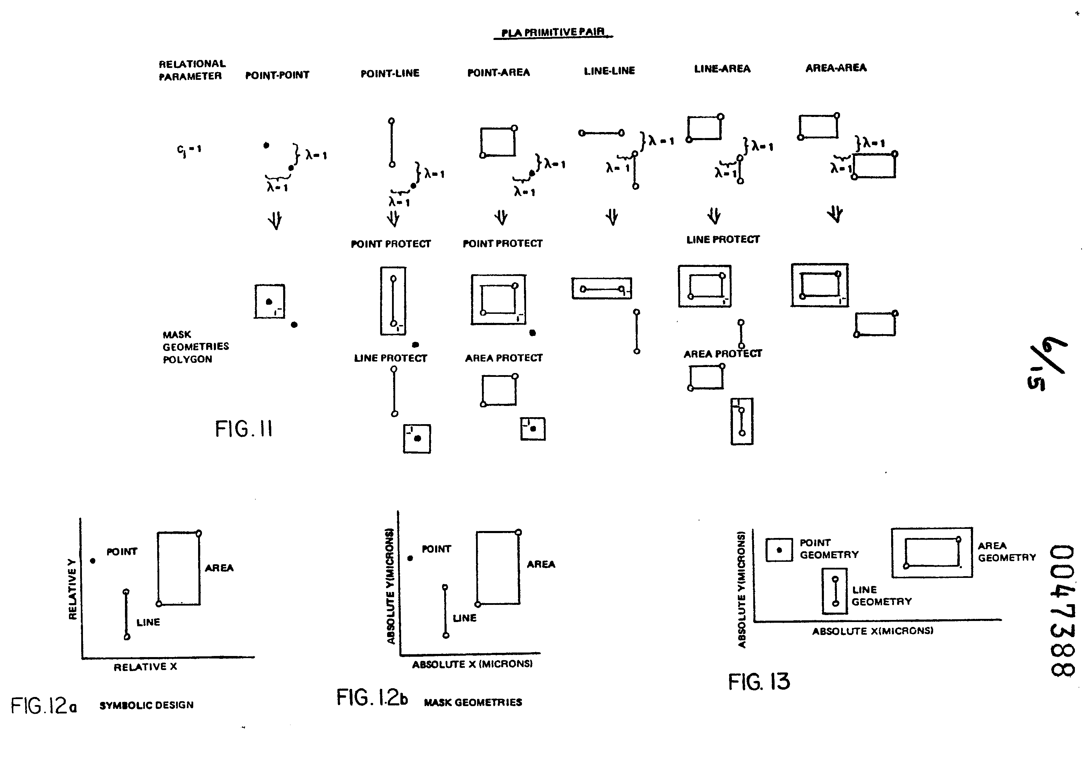

As shown above, the candidate PLA possesses the PROTECT property. Therefore, the mutual vertex of the referenced PLA primitive is experiencing a "pushing" effect inflicted by the candidate PLA primitive. The degree of influence on the mutual vertex is defined by the PROTECT value. It should be noted that the PROTECT property only modifies the related vertex geometries of the referenced PLA primitive. The various combinations of PLA primitive pairs and the resulting mask geometries experiencing the PROTECT influence are presented in FIG. 11, showing the mask geometries for protect situation.

The Mask Geometry Equation

In transforming a PLA primitive into a rectangular mask geometry, an algorithmic procedure is utilized to map the edges defining the mask geometry. This transformation consists of two major requirements: namely, spatial placement of the mask geometry and the sizing and shaping of the edges defining the boundary of the mask geometry as a function of the proximity environment.

## Mask Geometry Placement

Even though the device designer is completely isolated from placement coordinates in µCAD, the compueter software still uses coordinates in defining PLA primitives that have been mapped on the color graphics screen. Each vertex defining a point and each vertex-pair defining a line or area is uniquely described as $(X_V/Y_V)$. This can be visualized in FIG. 12.

The absolute coordinates $(X_A/Y_A)$ of a PLA primitive is simply the relative symbolic design coordinates $(X_V/Y_V)$ multiplied by the scale factors $(\lambda_X, \lambda_Y)$; i.e., $X_A = \lambda_X X_V$ and $Y_A = \lambda_Y Y_V$. The scale factors represent the maximal resolvable distance, expressed in micron units, common to the process geometrics. The relative coordinates $(X_V/Y_V)$ and the absolute coordinates $(X_A/Y_A)$ are referenced to the 0/0 point of the module represented by the set of PLA primitives.

## Mask Geometry Edge Mapping

After mask geometry placement, the absolute vertex coordinates $(X_A/Y_A)$ are used to map the edges defining the mask geometries. The four edges defining the mask geometries boundary of a particular PLA primitive are considered to be elastically bound. · That is, each edge pair defines a boundary vertex. It is the placement of these vertices in the absolute coordinate domain that constitutes edge mapping. This can be illustrated in FIG. 13 as a continuation of the previous figures.

As seen in FIG. 13, it is the vertex placement that defines the edge mapping. Hence, the boundary definition that constitutes the primary mask geometry is referred to as SIZE. Now the edge mapping can be further influenced by the immediately surrounding PLA primitives. These environmental or proximity influences are referred to as COVER and PROTECT. The COVER influences result in remapping edges that experience a "pushing" or "pulling" effect; e.g., to provide an overlap geometry. The PROTECT influences result in remapping vertices that experience a "pushing" effect; e.g., island reshaping. This edge mapping concept can by symbolically represented and referred to as the mask geometry equation:

MASK GEOMETRY = SIZE + COVER - PROTECT

The requisite data, as derived from the process geometrics, underlying the mask geometry equation will be discussed in Section 9.0 entitled Specifying Mask Geometries.

The Mask Correction Factor Concept

Any microelectronics fabrication process is periodically being subjected to fine tuning procedures - all in the name of improving process yield and/or device performance. One of the salient features of symbolic design is that mask sets can be quickly regenerated from the verified layout. The correction factor concept, as previously discussed above, provides the analytical measurement that isolates the designer from the geometrical details accompanying the fabrication stages of lithography and processing.

The correction factor for any particular mask layer is composed of many components and can be defined as follows:

$$C_m = -(\Delta_M + \Delta_L + \Delta_P + \Delta_E)$$

Where: $\Delta_M$ represents corrections due to photo or e-beam lithography and step and repeat distortions.

$\Delta_L$ represents corrections due to photo resist exposure distortions.

$\Delta_P$ represents corrections due to processing distortions associated with diffusion, implanting or evaporation techniques.

$\Delta_E$ represents corrections due to physical structure variations with regard to electrical performance.

$m$ represents the mask layer subscript.

If $C_m > 0$, then the mask geometries will all be appropriately expanded, while if $C_m < 0$, then the mask geometries will all be appropriately shrunk. Thus it can be seen that $C_m$ embodies all the corrections actually occurring between the symbolic design and the physical structures implementing the finished device. The analytical versatility of this concept, coupled with its inherent simplicity, provides a powerful means of modifying mask geometries that isolates the designer from fabrication details throughout the design synthesis and analysis methodology.

0047388

Interactive Symbolic Circuit Analysis

As discussed above, μCAD provides means for the synthesis and analysis of modules to be integrated into VLSI device designs. The μCAD system is specialized for the device designer to provide an interactive facility for manipulating layout primitives (points, lines, areas) in symbolically composing circuit topology on a color graphics display. This section discusses the mathematical and software aspects of an interactive circuit analysis technique. This circuit analysis technique is predicated on the concept that to develop high performance (speed) VLSI circuitry, it will be essential to model the interconnect influences directly from the color enhanced-symbol layout together with the more conventional modeling of FET dynamics. To scale the circuit analysis problem so that it is implementable on an affordable minicomputer, a single circuit node formulation will be employed as opposed to the conventional circuit network formulation. This means that a single differential equation will describe the dynamics of sourcing charge into the node under analysis and the dynamics of sinking charge from the node under analysis.

As process geometrics shrink to submicron dimensions and the assault toward increased switching speeds continues unabated, the modeling of physical structures becomes increasingly relevant. Thus circuit analysis must be derived from the symbolic layout of circuit topology to appropriately consider the parasitic influences exerted by proximity. The determination of stray or parasitic influences must be derived from 4-dimensional $(x,y,z,t)$ electromagnetic field macromodels. The consideration of interconnect structure in the interactive circuit analysis methodology within MCAD is the innovative idea that will enable cost-effective high-speed VLSI circuit design.

Interactive computer graphics techniques are utilized to allow the designer to easily express his desire to perform circuit analysis at any point in the synthesis process. The node under analysis is designated by locating the cursor on a graphic primitive defining the nodal topology. The designer is afforded the opportunity to define the a priori nodal performance budget under the design intent concept of rigorously defining design objectives prior to composing the symbolic layout. The nodal response is displayed to the designer as an e-e trajectory with superimposed performance budget. This graphics presentation to the designer enables the designer to quickly judge design acceptability, or modification to FET drive capability or layout topology modification to reduce parasitic influence.

Basic Assumptions Underlying µCAD Circuit Analysis

In defining an alternative circuit analysis capability, the following itemized assumptions are assumed:

1. the designer is primarily interested in very specific performance questions while evaluating candidate symbolic layouts:
   a. how to interconnect active elements to create the required functional behavior!
   b. how to size FETs to drive loads to realize the required performance.
2. the primary source of charge to any node and the primary sink of charge from any node is produced by a logically enabled conduction path to $V_{DD}$ and ground, respectively;
3. incidental interactions with topologically adjacent nodes (proximity) is second-order, each individually unspectacular, although the accumulation of interactions must be accurately accounted for;
4. no one knows how to accurately model the conduction dynamics of FETs.

However, the displacement current into a channel is assumed
not to be a strong function of the source impedance. The
same applies to non-linear capacitive couplings;

5. the worst case conditions influencing the node under analysis
   can be easily specified by the designer.

Formulation of Circuit Analysis Within the $\mu$CAD Design Environment

Historically, circuit analysis has focused its attention on modeling
a multiport circuit network. In the present invention, circuit analysis will be
founded on a single node model. This proposed alternative conceptually
represents a scaling of the circuit analysis problem that appears
appropriate for interactive processing on a mini (micro) computer.
This scaling also appears appropriate from the designers standpoint.
Now the designer can concentrate on formulating the worst case conditions
of sourcing charge into a node or sinking charge from a node in striving
to satisfy performance budgets.

The salient points underlying the circuit analysis
formulation are the following:

1. formulate a generalized model for any node in a VLSI network;

2. as the symbolic layout is being interactively composed,
   accumulate, node by node, the incidence and extent of each
   proximity relationship which define specific couplings
   between conductive paths;

3. solve the nonlinear ordinary differential equation (ODE) for
   only one node (node under analysis). Use worst case
   approximations to represent whats happening elsewhere;

4. extract an arbitrarily close straight line approximation to
   the ODE solution-trajectory;

5.  store this ODE trajectory representation of each node in
    a data structure that provides rapid access for subsequent
    nodal analyses;

6.  display the ODE trajectory representation to the designer
    so he can quickly realize the consequences of any choice
    of layout topology. Superimpose the performance budgets
    to immediately compare the response of present circuit
    toplogy to design targets;

7.  provide for the evolution in device physics and process
    scaling by using multivariable functional relationships
    to describe the nonlinear conductance and capacitance
    characteristics of FETs, diodes and interconnect structures.

Mask Geometries Algorithm

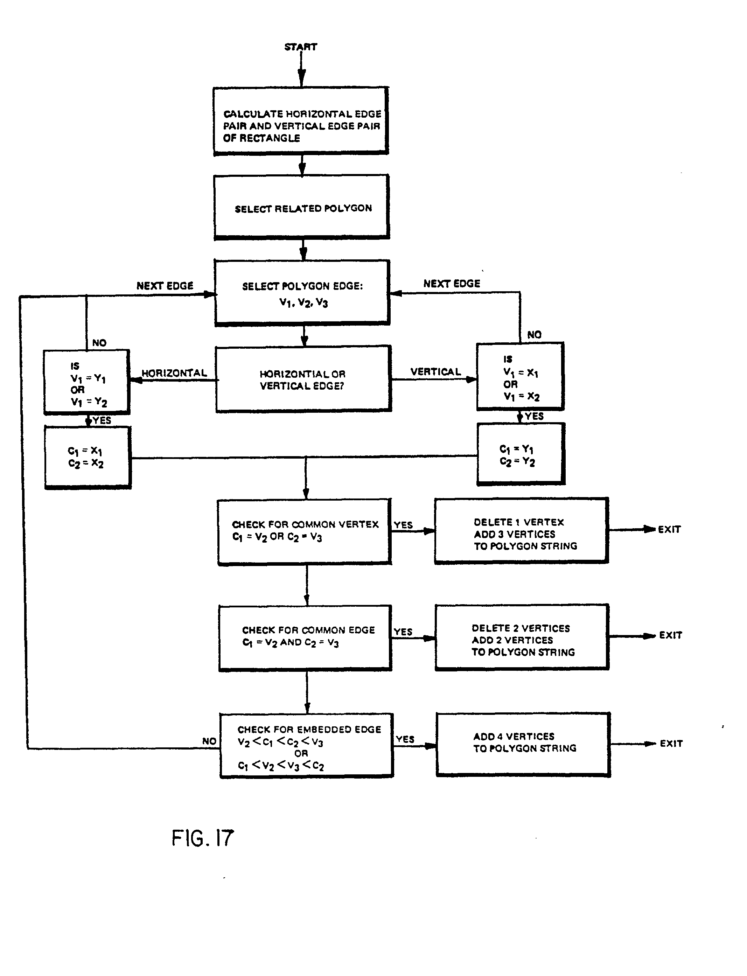

The purpose of the mask geometries algorithm is to generate mask polygons from PLA primitives, and is illustrated in FIG. 17. Since the steps in the flow-chart shown in FIG. 17 are readily apparent from the figure itself, a detailed explanation at this point is not necessary.

## Rectangle → Polygon Algorithm

The mask geometries algorithm transforms the PLA primitives into mask geometries that will be in the form of rectangles. When examining the proximity environment via primitive pairs, if a SIZE condition exists then the rectangle will be merged into the related polygon. The reasons for characterizing mask geometries in μCAD as polygons are as follows: (1) a cleaner, less cluttered, color graphics display of a mask geometries window results since redundant edge segments are eliminated, (2) a compressed data format can be used to store rectilinear polygons, (3) mask geometries characterized as polygons simplifies the delayed correction factor ($C_m$) concept since concern over contiguousness is greatly reduced, (4) polygon decomposition algorithms can be independently optimized for photo lithography and e-beam lithography processes, and (5) it affords an opportunity to develop a high-level lithography data interface language that takes advantage of arraying and replication schemes utilized in VLSI device architectures.

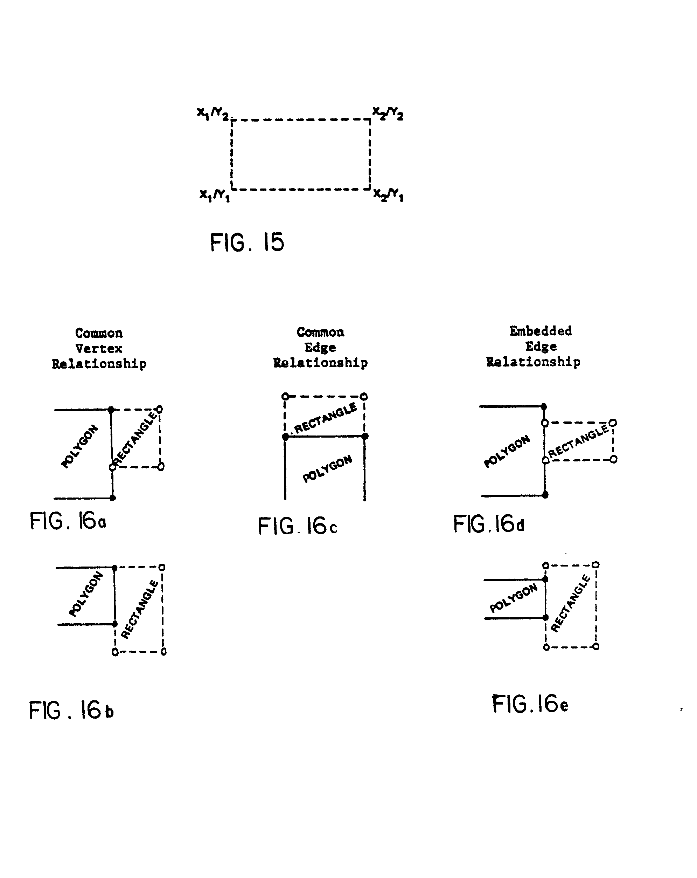

The rectangle to be merged into a related polygon can be envisioned in FIG. 15.

This rectangle can further be characterized as consisting of a horizonal edge pair and a vertical edge pair. Each of these edge pairs can be defined as a coordinate 3-tuple, that is:

horizontal edges:   $(Y_1, X_1, X_2)$ and $(Y_2, X_1, X_2)$

vertical edges:     $(X_1, Y_1, Y_2)$ and $(X_2, Y_1, Y_2)$

These coordinate 3-tuples will be used by the RECTANGLE →
POLYGON algorithm. Now the related rectilinear polygon can be defined
as a coordinate n-tuple as follows:

$$\text{rectilinear polygon} = X_1, \; Y_1 \;\; \overset{X_2}{Y_2} \;\;, \;\; \overset{Y_3}{X_3} \;\;, \;\; \overset{X_4}{Y_4} \;\;, \; \cdots \;, \; \overset{X_n}{Y_n} \;\; ;$$

In sequencing through the coordinate n-tuple string defining the
polygon, the respective edges of the polygon can be sequentially
defined as follows:

|  | $V_1$ | $V_2$ | $V_3$ |  | $V_1$ | $V_2$ | $V_3$ |  |
|---|---|---|---|---|---|---|---|---|
| Edge No. 1 | $Y_1$ | $X_1$ | $X_2$ | (Horizonal) | $X_1$ | $Y_1$ | $Y_2$ | (Vertical) |
| Edge No. 2 | $X_2$ | $Y_1$ | $Y_3$ | (Vertical) | $Y_2$ | $X_1$ | $X_3$ | (Horizontal) |
| Edge No. 3 | $Y_3$ | $X_2$ | $X_4$ | (Horizontal) | $X_3$ | $Y_2$ | $Y_4$ | (Vertical) |
| Edge No. 4 | $X_4$ | $Y_3$ | $Y_5$ | (Vertical) | $Y_4$ | $X_3$ | $X_5$ | (Horizontal) |

Where $V_1, V_2, V_3$ is the coordinate 3-tuple
defining the horizontal and vertical edges of the
polygon.

The relationships existing between the rectangle and the polygon can be classified as follows in FIG. 16a, b, c, d, and e.

FIG. 16a and 16b show 3 vertices to be added to polygon, 1 vertex to be deleted from polygon.

FIG. 16c shows 2 vertices to be added to polygon, 2 vertices to be deleted from polygon.

FIG. 16d and 16e shows 4 vertices to be added to polygon.

The RECTANGLE → POLYGON Algorithm can now be defined in FIG. 17 which utilizes the nomenclature presented in this section.

Rectangle → Polygon Algorithm

The rectangle → polygon algorithm flow chart is shown in FIG. 17, and is believed self-explanatory.

Specifying Mask Geometries

Up to this point in the discussion, the algorithmic aspects underlying µCAD mask geometries has been presented in a generalized manner. The intent was to demonstrate the versatility of the mask geometries algorithm and its generalization due to the mathematical concepts utilized. In this section, a language is proposed that will enable the mathematical variables to receive values relating to a given fabrication process. This set of statements resides on floppy disk in a repository referred to as the Process Library. It will enable the design community to design several modules, in a given process, to be decoupled from the analytical details accompanying the specification of mask geometries.

Language Definition

Upper case letters represent constants in the language while lower case letters represent language variables which the designer must quantify.

```
Scale:      <x-scale>/<y-scale>
Mask:       <mask name> = <mask number>, <mask correction factor>
            (<display color>);

Size
Cover   :   <number> = <design color> [<design symbol>], ···;
Protect
```

Where the variables of the mask geometries language can take on the following values:

```
<display color>  :: =  color
<design color>   :: =  color
<color>  :: = R/G/Y/B/M/C/W
```

Where: R means red

G means green

Y means yellow

B means blue

M means magenta

C means cyan

W means white

<design symbol> :: = O/X

Where: O means FET

X means contact

The mask geometries language consists of only five statements in which the SIZE, COVER, and PROTECT statements are collected and preceded by a MASK statement. For an experimental CMOS/SOS process, the poly-silicon mask would be simply specified as follows:

```
SCALE:  4.5/4.5;
MASK:   POLY = 110, + 8 (Y);
SIZE:   1 = GO, BO, CO:
        1 = Y;
        2 = RX;
```

Note that the numerical values sizing the PLA primitives are given in nominal 1X values from the grid centerline in units of microns. Numerical values may be integer (3) or real (4.15).

An Example - The Problem of 4 Adjacent Points with Unequal Sizes

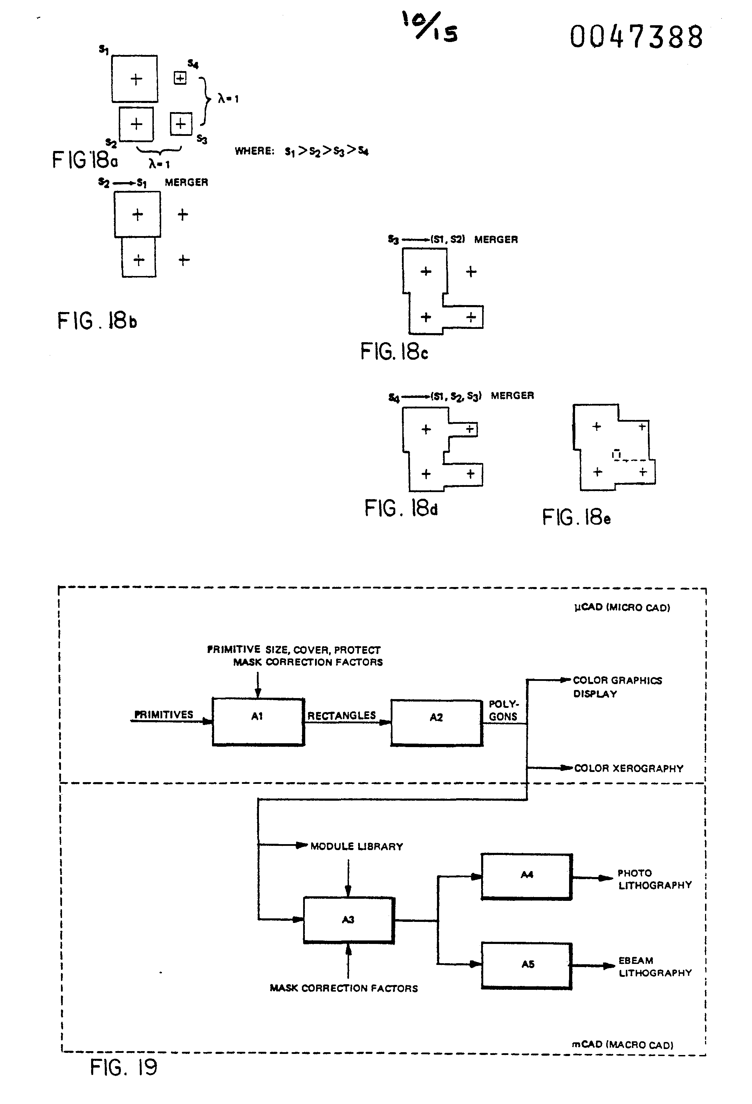

The 4 adjacent points problem has been a rather troublesome problem to the conventional mask geometries algorithm. Consequently, this has become a classical problem with regard to mask geometry contiguousness in symbolic design. It can be defined in FIG. 18a, b, c, d, and e.

This example also illustrates the inherent advantage incorporated into the mask geometries algorithm with regard to color graphics displaying. All the common edges of the rectangles within the polygon are deleted. This greatly enhances the color graphics display of mask geometries to the designer and facilities electronic measuring of intra and inter mask geometry spacings.

The present invention presents the paramount concepts and algorithsm underlying the µCAD mask geometries capabilities. It is an interactive means available to device, lithography and process engineers to explore mask geometry design. The mask geometries are derived from the PLA primitives defining the symbolic design of a VLSI module. A very simple language is used to specify the SIZE, COVER and PROTECT data related to any specific process. However, in designing symbolic modules, the device designer is not required to specify these data since it resides within the Process Library.

In the µCAD interactive design environment, the designer remains insulated from the details associated with mask geometries. In synthesizing the module design the designer utilizes the PLA primitives to compose the symbolic design on a color graphics screen. But at any point in the synthesis process, if the designer wishes to explore mask geometries, he can conveniently do so. This feature has not been available in conventional CAD methodology until later in the design cycle. As process geometrics continue to shrink toward submicron levels, the ability to examine mask geometries via color graphics displays will be the only cost-effective means available. This will eliminate the need for conventional color guides, as well as colored pencils and mylar layout schematics.

The global strategy being suggested to provide technical versatility and cost effectiveness in mask generation for VLSI devices can be portrayed in FIG. 19.

Algorithm A1:  symbolic design primitives to mask rectangles
Algorithm A2:  mask rectangles to mask polygons
Algorithm A3:  design assembler with optional delayed correction
factor modification
Algorithm A4:  photo lithography polygon fracturing
Algorithm A5:  e-beam lithography polygon fracturing

Module Level Logic Simulation (μCAD)

A completely new approach to logic simulation is proposed to support synthesis activities at the module level. The purpose of module-level logic simulation is to check the consistency of partially defined layout structures by a comparison with the functional specifications received from mCAD. The models to be exercised will be derived from the symbolic layout. This means that the logic simulation activities are performed concurrently with the layout design activities, hence, the need to develop a powerful interactive logic simulation capability. The emphasis must be placed on a simple means of initializing nodes and identifying nodes whose logic response transitions are to be displayed for analysis. This interactive logic simulation concept is also intended to support evaluation of candidate testability implementations which will become an integral part of the layout design problem. This means a powerful local simulation capability of time-stepping the model to study stimuli-response relationships during test mode operations.

Interactive Symbolic Circuit Analysis

There are two important technology trends that must be recognized when developing a circuit analysis methodology. First, as process geometrics continue to decrease, parasitic influences tend to become first-order effects with increases in switching speeds. Secondly, FET schematics are abstractions and do not reflect the distributed physical structures in the silicon or sapphire device. Hence, derivation of the equivalent circuit and the determination of parameter values should come from the symbolic layout design.

The data structure supporting the color graphics display functions can be transformed into a graph data structure defining the topological properties of the symbolic layout. This graph structure will essentially define the equivalent circuit to be analyzed. The vertices of the graph structure will represent equipotential nodes while the edges of the graph structure will represent the electrical dynamic characteristics of passive elements (capacitors, resistors), and active elements (diodes, FETs).

An electrical transformation language will be developed which will relate passive and active element parameters to the symbolic design entities (points, lines, area) used by the designer. This language concept is similar to the mask geometries transformation language (MANN4) that has been used for many years. Macro FET models must be developed which greatly reduce the functional model dimensionality over the conventional circuit analysis models existing today. Techniques must be developed that allow the designer to easily specify initial conditions and identify nodes whose transient responses are to be displayed.

The power of being able to perform circuit analysis evaluations, at any time a designer deems it profitable, is an extremely exciting concept. As performance trends toward developing higher speed logic, the need for equivalent circuits with greater fidelity becomes mandatory. It is essential that circuit analysis from the symbolic layout be recognized as a fundamental technical objective requiring allocation of significant resources.

Interactive symbolic Geometry Checking

Symbolic design enjoys a lower cost/FET ratio than any other CAD methodology at a small sacrifice in area/FET ratio. However, experience has indicated that symbolic design provides the designer with a conceptual, short-hand method for easily manipulating circuit topology without the need to think simultaneously about mask and process details. These process details are invisible to the designer because of the powerful mask geometries algorithm which transforms symbolic layout designs into mask geometries. Symbolic design can improve the area/FET ratio when used to create and compare candidate layouts for an equivalent function. Thus, symbolic design is a very effective design methodology.

Forbidden proximity relationships are detected by an exhaustive scan of the symbol environment. The neighborhood of a symbol, placed at grid point, $(i,j)$, is shown below:

```
        i+2    .    .    .    .    .
        i+1    .    .    .    .    .
rows     i     .    .  S_ij  .    .
        i-1    .    .    .    .    .
        i-2    .    .    .    .    .
             j-2  j-1   j   j+1  j+2
                      columns
```

Layout Symbol Environment for Geometry Checking

Symbolic geometry checking consists of verifying that process-dependent patterns of symbols are not to be found in the neighborhood of the symbol $S_{ij}$. The symbolic geometry checking algorithm simply performs a two-dimensional interaction over the entire symbolic layout of the device design. For M symbolic geometry checks to verify intra and inter layer process geometries, this means (M) $(X_{max})$ total geometry checks must be performed for a symbolic layout size of $X_{max}$ by $Y_{max}$, where $X_{max}$, $Y_{max}$ <1500.

This problem dimensionality must be contrasted against the conventional polygonal-mask layer approach to appreciate the cost advantage. In the conventional approach, intramask and intermask polygonal geometries are conjunctioned and disjunctioned to determine violations in mask geometries and edge-pair spacings. If we assume N polygons per mask layer and M mask layers per device, the number of polygonal geometry checks will exceed (M) (N) (N-1)/2.

Since $N >> 10^5$ for VLSI devices, the number of polygonal geometry checks to be performed is exceedingly large ($>10^{10}$). This dimensionality obviously nullifies the effectiveness of this concept for VLSI devices.

In the μCAD concept, symbolic geometry checking will be a derivative of the conventional symbolic geometry checking previously discussed. Since the symbolic layout on the color graphics display is represented as an ordered point-line-area list, the symbolic geometry checking algorithm will involve a limited scan of this list. These symbolic geometry checks fundamentally involve point-line, point-area, and line-area relationships. The dimensionality of this concept is approximately $(C_{PL})$ $(C_{PA})$ $(C_{LA})/2$ where $C_{ij}$ is the number of combinations between i and j. This dimensionality is considerably less than what is presently being experienced with our conventional symbolic geometry checking concepts.

The advantage noted in symbolic geometry checking makes it essential that symbolic geometry checking be integrated into the new symbolic design methodology. As the design directives are being supplied to the software for appropriate color graphics displaying, they must be concurrently checked for any geometry violations. This means that these ground rule violations are being detected as the symbolic layout is being synthesized. In present design environments, these ground rule violations are being detected in a post-layout-digitizing activity. To implement the necessary layout alterations generally results in pertubating the layout in such a manner as to decrease FET density. This reduction in spatial optimization, plus the added design costs of implementing the layout changes, has an impact on device performance, buildability characteristics and ultimately costs. Concurrent symbolic geometry checking with interactive symbolic layout design overcomes these existing deficiencies.

## 5 Color Enhanced - Symbolic Design

Symbolic design concepts are important features. The black and white (2 color) multisymbol printed schematic, characterizing a microelectronic device design, has served a variety of device applications and processes since the 1960's in a technically and economically effective manner.

However, in the present invention, CAD captures the added dimensionality that color can provide in all aspects of device design. The introduction of color simplifies the representation of device design. The following table illustrates a candidate color-symbol assignment for a CMOS/SOS technology:

| Symbolic Layout Entity | Structure | Symbolic Layout Entity | Structure |
|---|---|---|---|
| Blue line/area | $p_+^-$ epi | Blue X | $p_+^-$-al contact |
| Green line/area | $n^+$ epi | Green X | $n^-$-al contact |
| Yellow line/area | polysilicon | Red X | polysi-al contact |
| Red line/area | aluminum | Blue O | pFET |
| | | Green O | nFET |

The utilization of color enhances and facilitates the interpretation of graphical presentations. Color can be used to highlight computer derived labels, flags and error conditions. Color definitely provides an additional dimensionality in man-computer communications.

FIG. 11 illustrates the mask geometries for a protect situation according to the present invention;

FIG. 12a and 12b illustrate the geometric placement according to the present invention according to both symbolic design and mask geometry;

FIG. 13 illustrates the mask geometry edge mapping according to the present invention;

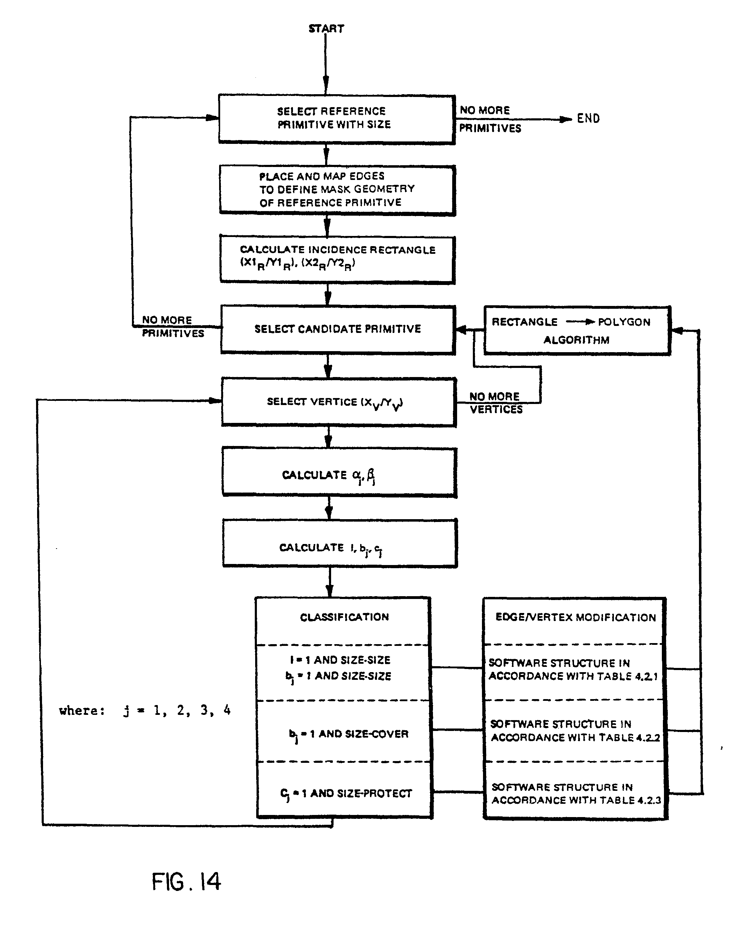

FIG. 14 illustrates the mask geometries algorithm in a flow chart form according to the present invention;

FIG. 15 illustrates a representation of a rectangle according to the present invention;

FIG. 16a to 16e illustrate the relationship between the rectangle and the polygon according to the present invention;

FIG. 17 illustrates a flow chart of the rectangle to polygon algorithm according to the present invention;

FIG. 18a, b, c, d and e illustrate the problem of four adjacent points with unequal sizes according to the present invention;

FIG. 19 illustrates the global strategy of the design system according to the present invention;

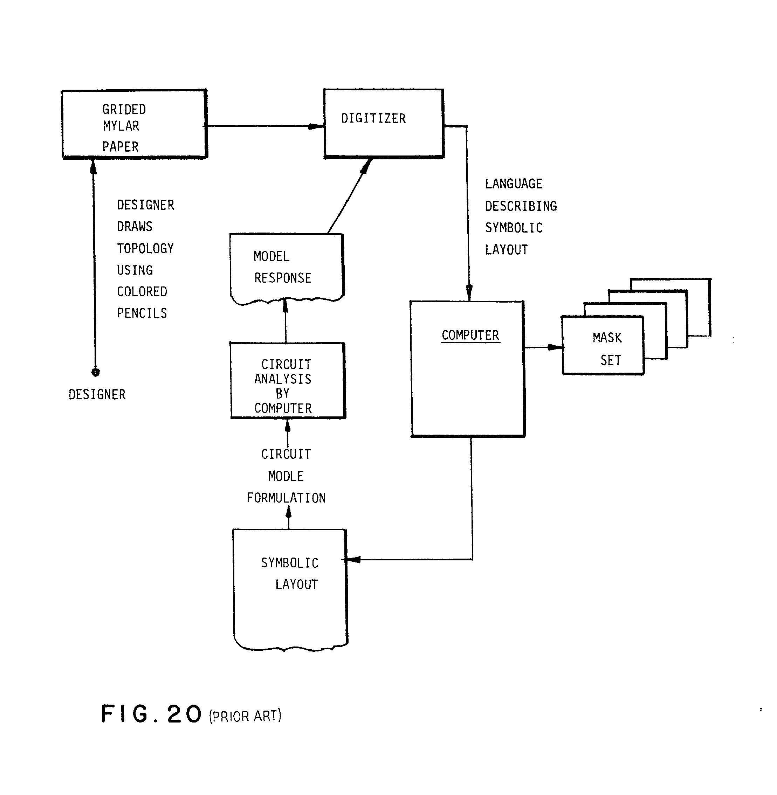

FIG. 20 shows a highly simplified block diagram of the computer-aided design process of the prior art; and

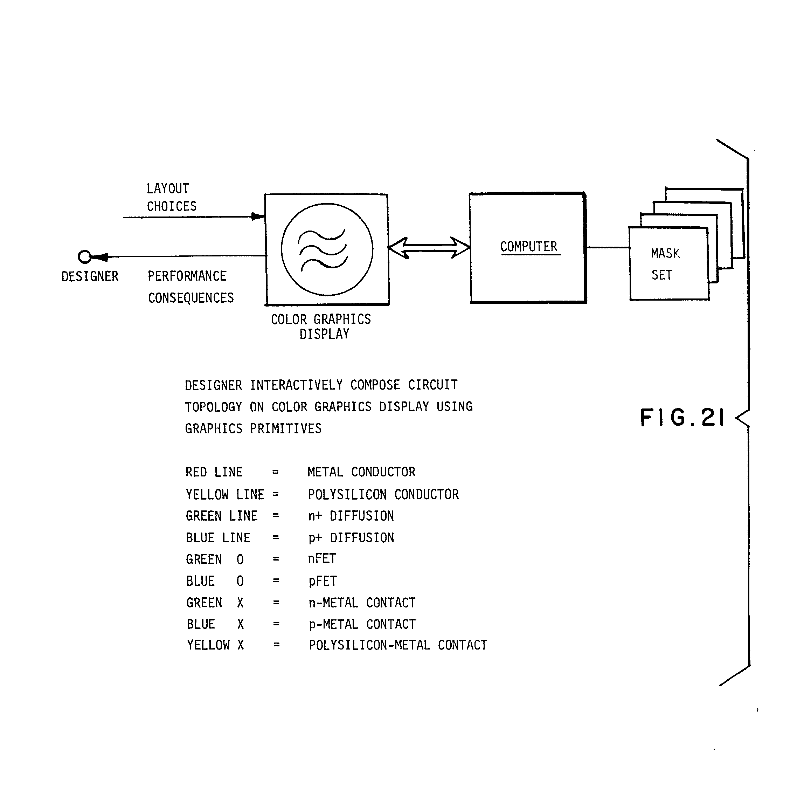

FIG. 21 is a highly simplified block diagram of the computer-aided design system according to the present invention.

The identification of the various components in the two figures are labelled in the figures and therefore detailed description is unnecessary.

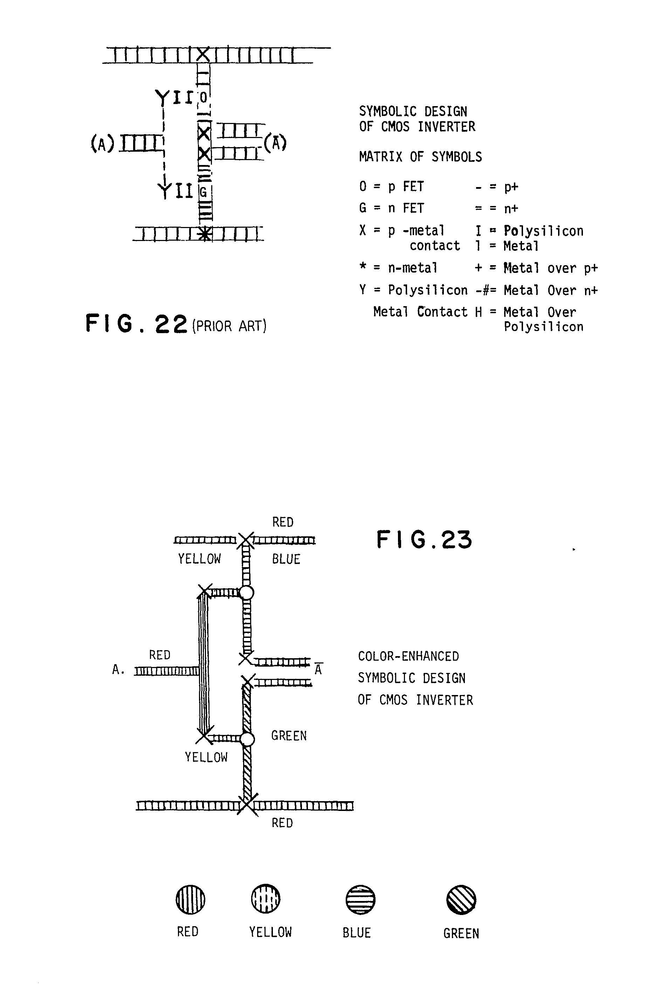

FIG. 22 is a representation of the symbolic design of a CMOS inverter according to the prior art; and FIG. 23 is a representation of the same CMOS inverter as drawn in sumbolic design with a computer-aided design system according to the present invention.

The explanation and interpretation of the symbolic designs is evident from the definitions given in the figures.

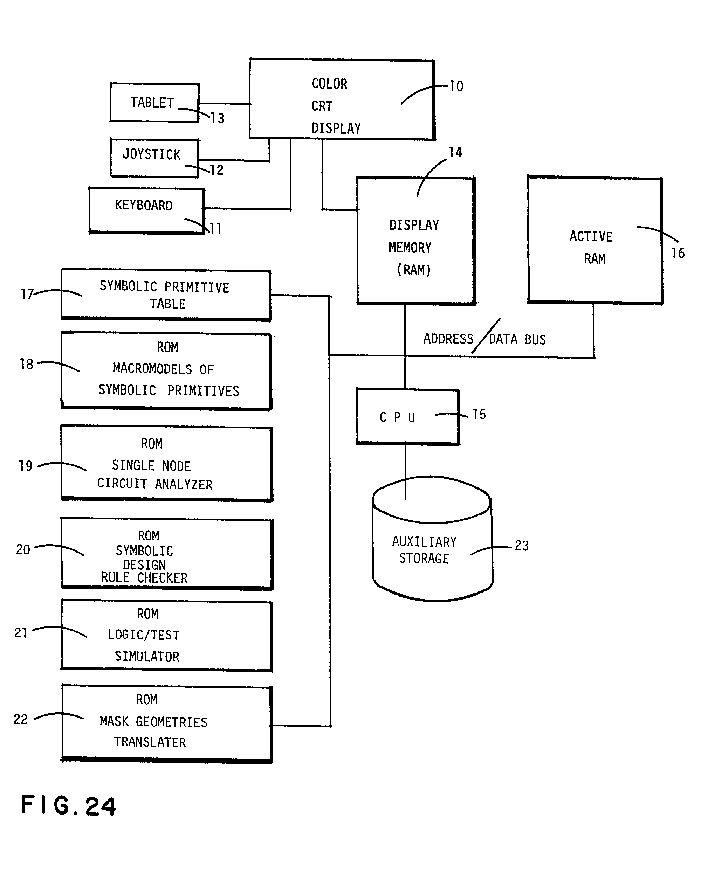

FIG. 24 is a highly simplified block diagram of a system implementation of the computer-aided design system according to the present invention.

Claims

1. A computer aided design system comprising:

means for representing a plurality of electronic devices having respective predetermined electronic operating characteristics and respective predetermined geometrical configurations on a display;

means for representing electrical connections between said electronic devices on said display to produce a representation of an electronic circuit on said display;

means for automatically calculating the performance of said circuit defined by said representation of said circuit; and

means for testing the geometrical configurations defined by said representation of said electronic circuit against predetermined geometrical design criteria.

0047388

2. A computer aided design system as defined in claim 1, wherein said means for calculating the performance of said circuit further comprises means for displaying the calculated performance on said display.

3. A computer aided design system as defined in claim 1, wherein said means for testing the geometrical configurations further comprises means for substantially simultaneously checking the electrical circuit against predetermined behavioral design criteria.

4. A computer aided design system as defined in claim 1, wh further comprising means for generating mass polygons from said representation of said electronic circuit.

5. A computer aided design system as defined in claim 4, wherein said mass polygons provide for edge vertex modification depending upon the symbolic layer environment.

FIG. 1

FIG. 2

Point:

INCIDENCE RECTANGLE

$$X1_R = X_P - 1 \qquad Y1_R = Y_P - 1$$

$$X2_R = X_P + 1 \qquad Y2_R = Y_P + 1$$

FIG. 3a

Line:

INCIDENCE RECTANGLE

$$X1_R = X1_L - 1 \qquad Y1_R = Y1_L - 1$$

$$X2_R = X2_L + 1 \qquad Y2_R = Y2_L + 1$$

FIG. 3b

Area:

INCIDENCE RECTANGLE

$$X1_R = X1_A - 1 \qquad Y1_R = Y1_A - 1$$

$$X2_R = X2_A + 1 \qquad Y2_R = Y2_A + 1$$

FIG. 3c

FIG. 4

FIG. 5a

Where:

$$b_1 = \beta_1 \, \alpha_2 \, \alpha_4 \qquad\qquad c_1 = \beta_1 \, \beta_2$$

$$b_2 = \beta_2 \, \alpha_1 \, \alpha_3 \qquad\qquad c_2 = \beta_2 \, \beta_3$$

$$b_3 = \beta_3 \, \alpha_2 \, \alpha_4 \qquad\qquad c_3 = \beta_3 \, \beta_4$$

$$b_4 = \beta_4 \, \alpha_1 \, \alpha_3 \qquad\qquad c_4 = \beta_1 \, \beta_4$$

FIG. 5b     and:

$$B = \sum_{j=1}^{4} b_j \qquad\qquad C = \sum_{j=1}^{4} c_j$$

**EXPLICIT SITUATION ($\lambda = 0$)**

CANDIDATE PLA WITH SIZE

REFERENCE PLA WITH SIZE

CANDIDATE PLA WITH SIZE

FIG. 6a

**IMPLICIT SITUATION ($\lambda = 1$)**

CANDIDATE PLA WITH SIZE

$\lambda = 1$

$\lambda = 1$

REFERENCE PLA WITH SIZE

$\lambda = 1$

$\lambda = 1$

CANDIDATE PLA WITH SIZE

FIG. 6b

CANDIDATE PLA WITH COVER

$\lambda = 1$

$\lambda = 1$

REFERENCE PLA WITH SIZE

$\lambda = 1$

$\lambda = 1$

CANDIDATE PLA WITH COVER

FIG. 7

$\lambda = 1$

CANDIDATE PLA WITH PROTECT

$\lambda = 1$

REFERENCE PLA WITH SIZE

$\lambda = 1$

CANDIDATE PLA WITH PROTECT

$\lambda = 1$

FIG. 8

PLA PRIMITIVE PAIR

| RELATIONAL PARAMETER | POINT-POINT | POINT-LINE | POINT-AREA | LINE-LINE | LINE-AREA | AREA-AREA |
|---|---|---|---|---|---|---|

$i = 1$

(COINCIDENCE)

MASK GEOMETRIES POLYGON

$b_j = 1$

MASK GEOMETRICS POLYGON

$c = 1$

THE C=1 (CLASS III CORNER RELATIONSHIP) IS A PHYSICALLY REALIZABLE PLA PRIMITIVE PAIR RELATIONSHIP BUT DOES NOT RESULT IN A PERMITTED MASK GEOMETRY BECAUSE OF THE DIAGONAL RELATIONSHIP; HENCE IS FLAGGED AS AN ALGORITHMIC ERROR.

FIG. 9

0047388

PLA PRIMITIVE PAIR

| RELATIONAL PARAMETER | POINT-POINT | POINT-LINE | POINT-AREA | LINE-LINE | LINE-AREA | AREA-AREA |
|---|---|---|---|---|---|---|

$b_j = 1$

MASK GEOMETRIES POLYGON

POINT COVERING

POINT COVERING

LINE COVERING

LINE COVERING

AREA COVERING

AREA COVERING

FIG. 10

PLA PRIMITIVE PAIR

FIG. 11

FIG. 12a   SYMBOLIC DESIGN

FIG. 12b   MASK GEOMETRIES

FIG. 13

6/5

0047388

START

SELECT REFERENCE
PRIMITIVE WITH SIZE
→ NO MORE
PRIMITIVES → END

PLACE AND MAP EDGES
TO DEFINE MASK GEOMETRY
OF REFERENCE PRIMITIVE

CALCULATE INCIDENCE RECTANGLE
$(X1_R/Y1_R)$, $(X2_R/Y2_R)$

NO MORE
PRIMITIVES → SELECT CANDIDATE PRIMITIVE ← RECTANGLE ──► POLYGON
ALGORITHM

SELECT VERTICE $(X_V/Y_V)$ → NO MORE
VERTICES

CALCULATE $\alpha_j$, $\beta_j$

CALCULATE $l$, $b_j$, $c_j$

| CLASSIFICATION | EDGE/VERTEX MODIFICATION |
|---|---|
| $l = 1$ AND SIZE-SIZE<br>$b_j = 1$ AND SIZE-SIZE | SOFTWARE STRUCTURE IN<br>ACCORDANCE WITH TABLE 4.2.1 |
| $b_j = 1$ AND SIZE-COVER | SOFTWARE STRUCTURE IN<br>ACCORDANCE WITH TABLE 4.2.2 |
| $c_j = 1$ AND SIZE-PROTECT | SOFTWARE STRUCTURE IN<br>ACCORDANCE WITH TABLE 4.2.3 |

where: $j = 1, 2, 3, 4$

FIG. 14

0047388

$x_1/y_2$             $x_2/y_2$

$x_1/y_1$             $x_2/y_1$

FIG. 15

Common
Vertex
Relationship

Common
Edge
Relationship

Embedded
Edge
Relationship

POLYGON   RECTANGLE

FIG. 16a

RECTANGLE
POLYGON

FIG. 16c

POLYGON   RECTANGLE

FIG.16d

POLYGON   RECTANGLE

FIG. 16b

POLYGON   RECTANGLE

FIG.16e

START

CALCULATE HORIZONTAL EDGE
PAIR AND VERTICAL EDGE PAIR
OF RECTANGLE

SELECT RELATED POLYGON

NEXT EDGE → SELECT POLYGON EDGE:
$V_1$, $V_2$, $V_3$ ← NEXT EDGE

NO

IS
$V_1 = Y_1$
OR
$V_1 = Y_2$ ← HORIZONTAL HORIZONTIAL OR
VERTICAL EDGE? VERTICAL → IS
$V_1 = X_1$
OR
$V_1 = X_2$

NO

YES

$C_1 = X_1$
$C_2 = X_2$

YES

$C_1 = Y_1$
$C_2 = Y_2$

CHECK FOR COMMON VERTEX
$C_1 = V_2$ OR $C_2 = V_3$ YES → DELETE 1 VERTEX
ADD 3 VERTICES
TO POLYGON STRING → EXIT

CHECK FOR COMMON EDGE
$C_1 = V_2$ AND $C_2 = V_3$ YES → DELETE 2 VERTICES
ADD 2 VERTICES
TO POLYGON STRING → EXIT

NO CHECK FOR EMBEDDED EDGE
$V_2 < C_1 < C_2 < V_3$
OR
$C_1 < V_2 < V_3 < C_2$ YES → ADD 4 VERTICES
TO POLYGON STRING → EXIT

FIG. 17

0047388

FIG 18a

WHERE: $s_1 > s_2 > s_3 > s_4$

$s_2 \longrightarrow s_1$   MERGER

FIG. 18b

$s_3 \longrightarrow (S1, S2)$   MERGER

FIG. 18c

$s_4 \longrightarrow (S1, S2, S3)$   MERGER

FIG. 18d

FIG. 18e

μCAD (MICRO CAD)

PRIMITIVE SIZE, COVER, PROTECT
MASK CORRECTION FACTORS

PRIMITIVES → A1 → RECTANGLES → A2 → POLY-GONS

COLOR GRAPHICS DISPLAY

COLOR XEROGRAPHY

MODULE LIBRARY

A3 → A4 → PHOTO LITHOGRAPHY

A5 → EBEAM LITHOGRAPHY

MASK CORRECTION FACTORS

mCAD (MACRO CAD)

FIG. 19

0047388

FIG. 20 (PRIOR ART)

0047388

LAYOUT
CHOICES

COLOR GRAPHICS
DISPLAY

DESIGNER    PERFORMANCE
            CONSEQUENCES

COMPUTER

MASK
SET

FIG. 21

DESIGNER INTERACTIVELY COMPOSE CIRCUIT
TOPOLOGY ON COLOR GRAPHICS DISPLAY USING
GRAPHICS PRIMITIVES

RED LINE    =    METAL CONDUCTOR
YELLOW LINE =    POLYSILICON CONDUCTOR
GREEN LINE  =    n+ DIFFUSION
BLUE LINE   =    p+ DIFFUSION
GREEN  O    =    nFET
BLUE   O    =    pFET
GREEN  X    =    n-METAL CONTACT
BLUE   X    =    p-METAL CONTACT
YELLOW X    =    POLYSILICON-METAL CONTACT

**FIG. 22** (PRIOR ART)

SYMBOLIC DESIGN
OF CMOS INVERTER

MATRIX OF SYMBOLS

| | |
|---|---|
| O = p FET | - = p+ |
| G = n FET | = = n+ |
| X = p -metal | I = Polysilicon |
|     contact | 1 = Metal |
| * = n-metal | + = Metal over p+ |
| Y = Polysilicon -#= Metal Over n+ |
|   Metal Contact H = Metal Over |
|     Polysilicon |

**FIG.23**

COLOR-ENHANCED
SYMBOLIC DESIGN
OF CMOS INVERTER

RED    YELLOW    BLUE    GREEN

FIG.24

0047388

## FIG. 25

**READER**
1. READ FUNCTION KEYS
2. READ CURSOR

**ZOOMER**
1. ZOOM SYMBOLIC LAYOUT DOWN

**SCROLLER**
1. SCROLL SYMBOLIC LAYOUT RIGHT, LEFT, UP, DOWN

**MAPPER**
1. SET MAP MODE
2. CHARACTERIZE ALP

**ERASER**
1. SET ERASE MODE
2. CHARACTERIZE ALP

**REGISTER**
1. CLASSIFY NODE FOR GIVEN ALP
2. LABEL NODE
3. ADD GRAPHICS PROPERTIES OF ALP

**REGISTER**
1. CLASSIFY NODE FOR GIVEN ALP
2. DELETE NODAL PROPERTIES OF ALP
3. DELETE GRAPHICS PROPERTIES OF ALP

**SURVEYOR**
1. IDENTIFY PROXIMITY RELATIONSHIPS

MACROMODEL DERIVED FROM MICROFIELD ANALYSIS

**ACCOUNTANT**
1. QUANTIFY PROXIMITY RELATIONSHIPS OF ALPS

**ACCOUNTANT**
1. SUBSTRACT PROXIMITY RELATIONSHIPS OF ALP

**CHECKER**
1. CHECK R SERIES
2. CHECK C TOTAL
3. CHECK W
4. CHECK GROMETRICAL VIOLATION

VIOLATIONS

**RECORDER**
1. ADD NODAL TRANSACTION TO DESIGN LIST

**DISPLAYER**
1. ISSUE GRAPHICS COMMAND TO UPDATE DISPLAY